Europäisches Patentamt

European Patent Office

Office européen des brevets

(19)

(11) **EP 1 251 356 A2**

(12) **EUROPEAN PATENT APPLICATION**

(43) Date of publication:
**23.10.2002 Bulletin 2002/43**

(51) Int Cl.$^7$: **G01R 21/00**

(21) Application number: **02252323.7**

(22) Date of filing: **28.03.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **09.04.2001 US 829558**

(71) Applicant: **Eni Technology, Inc.**
**Rochester, NY 14623-3498 (US)**

(72) Inventor: **VanRemmen, William John**
**Geneseo, New York 1454 (US)**

(74) Representative: **Calderbank, Thomas Roger et al**
**MEWBURN ELLIS**
**York House**
**23 Kingsway**
**London WC2B 6HP (GB)**

(54) **Method and apparatus for determining the instantaneous power of a sinusoidal signal**

(57) A method and apparatus for determining the instantaneous power of a sinusoid signal is provided. Generally speaking, the apparatus (100) of the present invention determines the instantaneous power of a sinusoid signal without the need for filtering. This is accomplished based on the trigonometric identity $\sin^2 x + \cos^2 x = 1$. By first splitting (120) the incoming signal into two signals so that the resultant signals are 90 degrees out of phase with each other, and subsequently squaring (130,140) the split signals and adding (150) the squared split signals, the AC component of the original signal is effectively removed, leaving a DC representation of the square of the amplitude of the original signal without any residual AC component. The square of the amplitude of the original signal is directly proportional to the instantaneous power of the original signal.

FIG. 1

**Description**

The present invention relates generally to detecting power, and, in particular, to detecting the square of the amplitude of a sinusoidal signal, which is proportional to the instantaneous power of a sinusoid signal.

In many applications involving sinusoid signals, it is often desirable to measure the instantaneous power of the sinusoid signal. However, this can be particularly difficult in pulsed or modulated applications, such as in the field of communications or plasma generation.

Previous attempts to measure the power or amplitude of the sinusoid signal have focused on rectifying the signal and filtering out the remaining AC component of the resulting signal. This approach, however, introduces several problems. Often, the filters used employ reactive components, such as capacitors, to filter out the unwanted signal. The capacitors, however, require a specific time to charge. Often, this "rise time" of the capacitors may be longer than the pulse width of the signal that is to be measured. Accordingly, such filters are often undesirable since systems utilizing such filters are not capable of accurately measuring the amplitude or instantaneous power of a sinusoid signal that has a short pulse width envelope. Therefore, the filters impose a minimum pulse width or maximum modulation frequency on the sinusoid signals because of the time required for capacitors to charge. Accordingly, a need exists in the art for a device that overcomes these and other problems.

The presenr invention is a method and apparatus for determining the square of the amplitude or instantaneous power of an input signal.

According to a first embodiment, the device for measuring the square of the amplitude of an incoming signal comprises a splitting means for splitting the incoming signal into a first part and a second part, wherein the first part is 90 degrees out of phase with the second part, a first squaring means for squaring the first part, a second squaring means for squaring the second part, and an adding means for adding the squared first part and the squared second part, whereby the added squared first part and the added squared second part produce a output signal proportional to the square of the amplitude of the incoming signal.

According to another embodiment of the invention, the method for measuring the square of the amplitude of a sinusoid signal comprises splitting the sinusoid signal into a first part and a second part, wherein the first part is 90 degrees out of phase with the second part, squaring the first part, squaring the second part, and adding the squared first part and the squared second part, whereby the added squared first part and the added squared second part produce a output signal proportional to the square of the amplitude of the sinusoid signal.

**BRIEF DESCRIPTION OF THE DRAWINGS**

A more complete understanding of the present invention may be obtained by considering the following description in conjunction with the drawings in which:

FIG. 1 is a block diagram of an embodiment of the present invention;
FIG. 2 is a block diagram of an embodiment of the present invention;
FIG. 3 is a schematic diagram of an embodiment of the present invention; and
FIG. 4 is a flow diagram of the method of the present invention.

**DETAILED DESCRIPTION OF THE PREFERRED EMBODIMENT**

In accordance with the present invention, a method and apparatus for determining the instantaneous power of a sinusoid signal is provided. Generally speaking, and as discussed in detail below, the apparatus of the present invention determines the instantaneous power of a sinusoid signal without the need for filtering. This is accomplished based on the trigonometric identity $\sin^2 x + \cos^2 x = 1$. By first splitting the incoming signal into two signals so that the resultant signals are 90 degrees out of phase with each other, and subsequently squaring the split signals and adding the squared split signals, the AC component of the original signal is effectively removed, leaving a DC representation of the square of the amplitude of the original signal without any residual AC component. The square of the amplitude of the original signal is directly proportional to the instantaneous power of the original signal.

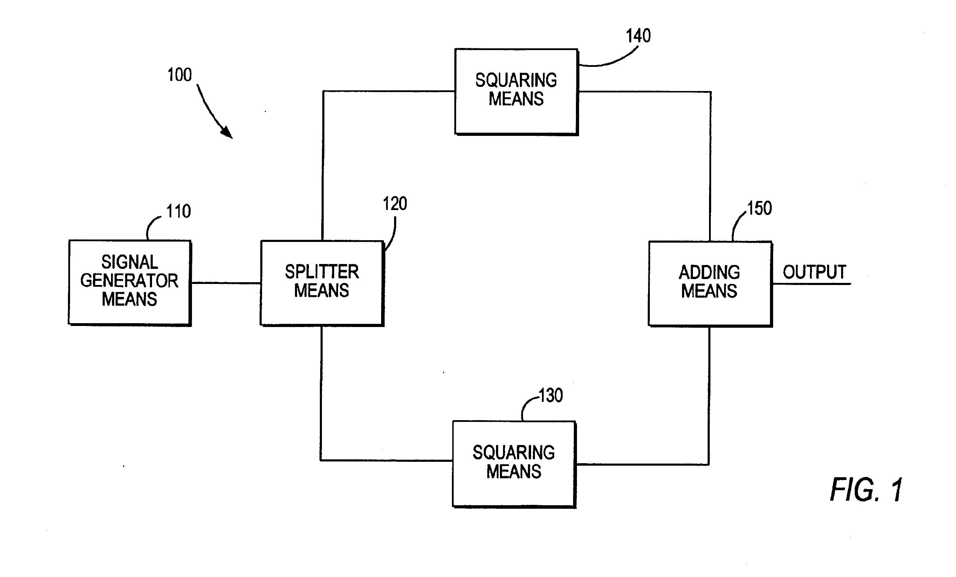

Referring now to the drawings in detail, and initially to FIG. 1, an overview of the system configuration of a preferred embodiment in accordance with the present invention is depicted. The apparatus 100 depicted in FIG. 1 generally comprises a signal generator means 110 for generating a sinusoid signal, a splitter means 120 for splitting the incoming signal into two portions that are 90 degrees out of phase with each other, squaring means 130, 140 for squaring each of the split signals and adding means 150 for adding the two squared signals together.

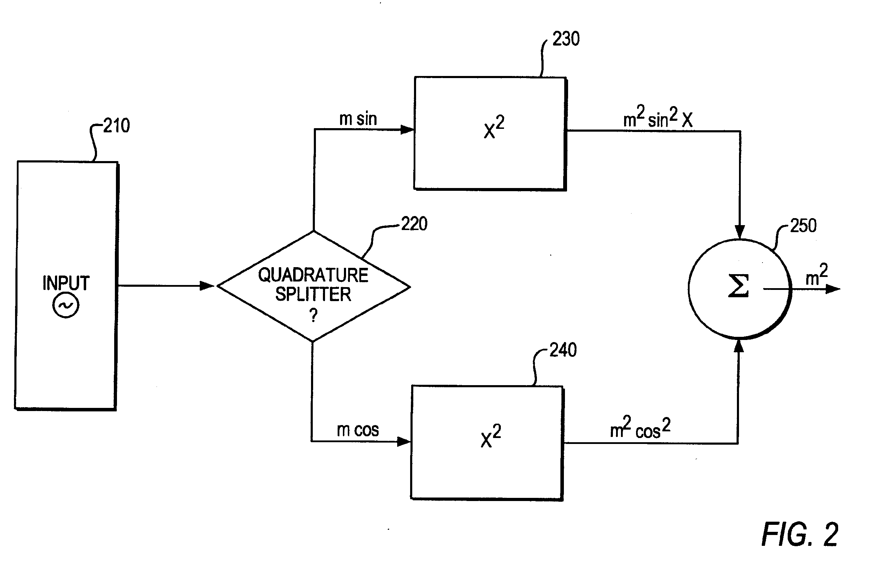

Turning now to FIG. 2, the apparatus of the present invention is shown in more detail. As illustrated, the input may be from virtually any device that generates a sinusoid signal. For example, the input signal may be generated by a directional coupler or other sensor suitable for generating a signal to be measured. It should be noted that any signal can be represented as a sum of sinusoids. Therefore, the applicability of the present invention should not be limited solely to sinusoid signals of a single frequency.

As further illustrated, in a preferred embodiment, the splitter means 120 is a quadrature splitter 220.

The quadrature splitter 220 is a well-known circuit element that splits the signal into two separate signals of equal amplitude with a 90 degree phase difference between the two separate signals. In essence, the quadrature splitter 220 splits the incoming signal into a cosine and sine versions of the input signal since

$$\sin(x+\pi/2) = \cos(x).$$

The input 210 is coupled to the quadrature splitter 220. The input is typically a radio frequency (RF) signal in the shape of a sinusoid signal with high frequency components. The RF signal can typically be generalized in the form of $2m\sin\theta$ where $2m$ is the amplitude of the sinusoid signal. The output of the quadrature splitter 220 is therefore two signals, $m\sin\theta$ and $m\cos\theta$. The first split signal is $m\sin\theta$ and the second split signal, which is a 90 degree phase shifted version of the first split signal, is $m\cos\theta$. Both signals are individually transmitted to a squaring means 230, 240 respectively. The output from the squaring means are $m^2\sin^2\theta$ and $m^2\cos^2\theta$ respectively. When the signals are summed at the summing circuit 250, the resultant output signal is $2m^2(\sin^2\theta + \cos^2\theta)$. Because of the trigonometric identity $\sin^2\theta + \cos^2\theta = 1$, the output signal is a constant DC output level of $2m^2$. Therefore, the output signal is directly proportional to the power of the input signal.

Squaring circuits 230, 240 receive the sine and cosine signal, respectively, and square the amplitude of each individual signal. Squaring circuits 230, 240 may be, for example, a four-quadrant voltage output analog multiplier such as model AD835, available from Analog Devices, Inc. of Norwood, Massachusetts. It should be noted that other squaring circuits may similarly be used.

Summing circuit 250 adds the two signals together, and outputs an output signal that is a DC representation of the square of the amplitude (power) of the original signal without any residual AC component. The summing circuit can be built in many different ways. For example, simply tying the signal lines together or other complex high-isolation methods can be used to create the summing circuit 250.

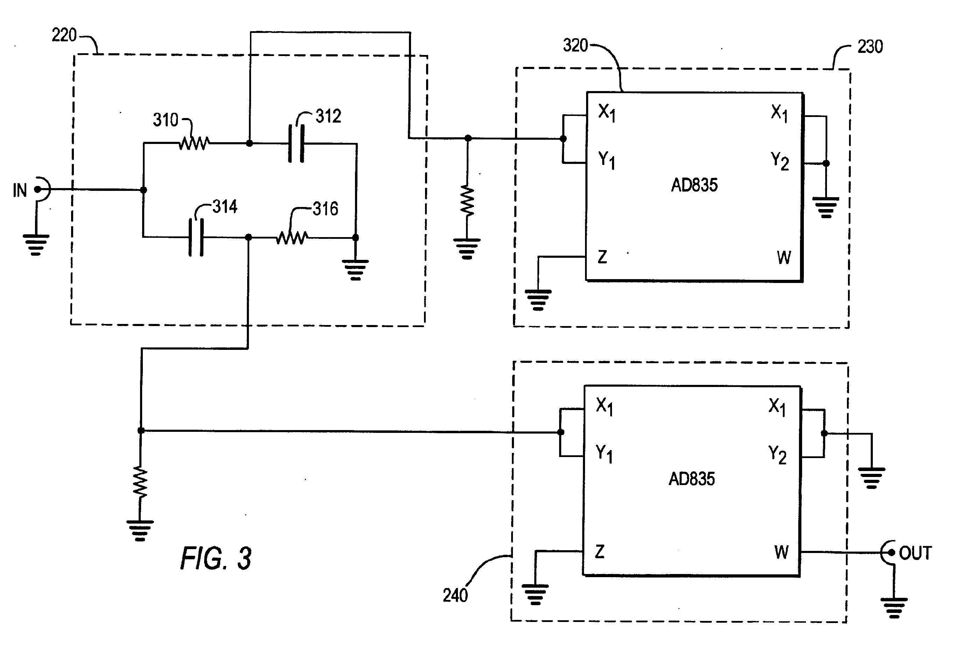

Turning now to FIG. 3, the circuit of the present invention is illustrated in an exemplary embodiment. As illustrated, the quadrature splitter 220 comprises two resistor capacitor pairs in a parallel arrangement. A first split signal is derived from the resistor 310. A second split signal is derived from the capacitor 314. The split signals are transmitted to the input ports of exemplary squaring circuits, as exemplified by the AD835 units, available from Analog Devices. The output port of one of the AD835 units 240 comprises the output DC signal of the present invention. The operation of the AD835 units are discussed in more detail below.

The operation of the device of FIG. 3 is detailed herein. The input signal is generated by the input signal generator 210. The input signal is a typically sinusoid signal with an amplitude of $2m$. The quadrature splitter is shown by block 220. The quadrature splitter preferably includes a resistor 310 coupled in series with a capacitor 312. The resistor capacitor pair 310, 312 are arranged in parallel with a matched resistor capacitor pair 314, 316. For an exemplary embodiment where the input signal has a frequency of 13.56 MHz, the quadrature splitter has the values of 51.1 ohms at resistors 310, 316. The matched capacitors 312 and 314 are 230 picofarads each. The output signals from the quadrature splitter 220 are two signals, to be input to two different squaring circuits 230, 240. The first split signal is $m\sin\theta$ and the second split signal is $m\cos\theta$ since the quadrature splitter of this implementation introduces losses which are reflected in the magnitudes of the resulting split signals.

The squaring circuits are preferably AD835 units 230, 240, available from Analog Devices. The AD835 units are squaring circuits with integrated summers. The AD835 units have two input ports $x_1$ and $y_1$ for performing a multiplication function. An additional input port z is provided for summing an additional input to the product of the $x_1$ and $y_1$ ports. An output port w therefore provides the logical function of $z + (x_1 \cdot y_1)$. As can be seen, the output port of the first AD835 unit 230 presents the logical function of $m\sin\theta \cdot m\sin\theta$.

As can be seen, the output port w of the first AD835 unit 230 is coupled to the input port z of the second AD835 unit 240. Therefore, the output port w of the second AD835 unit 240 presents the logical function of $m^2\sin^2\theta + (m\cos\theta \cdot m\cos\theta)$. The output port w of the second AD835 unit 240 is therefore, $2m^2$.

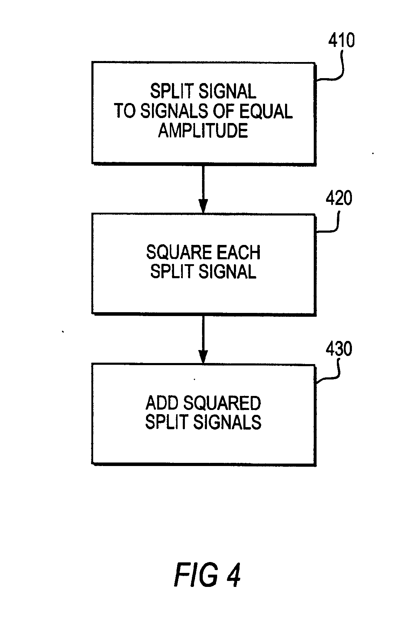

Turning now to FIG. 4, the process of the present invention for measuring the instantaneous power of a sinusoid signal is depicted. The signal is first split in step 410 into two signals of equal amplitude, where one signal is 90 degrees out of phase with the other. Next, in step 420, each signal is squared. Lastly, in step 430, the squared signals are added. The AC components of the squared signals are at twice the frequency of the unsquared signals and are therefore at twice the phase difference (180 degrees). The squaring process imparts a DC component to the squared signals. When the signals are summed together, the AC components of the squared signals cancel because they are 180 degrees out of phase with respect to each other. Therefore, the DC components (which are a result of the squaring and were not present in the original signal) to reach the output.

The above described invention feature many advantages. First, the output is directly $2m^2$ so that the power of the input signal can be directly derived from the output signal of the circuit of the present invention. Secondly, there are no low pass filters required so even arbitrarily fast modulated functions on the input signal can be recovered for the measurement of power.

Although the present invention is described in various illustrative embodiments, it is not intended to limit the invention to the precise embodiments disclosed herein. Accordingly, this description is to be construed as illustrative only. Those who are skilled in this technology can make various alterations and modifications without departing from t he scope and spirit of this invention. Therefore, the scope of the present invention shall be defined and protected by the following claims and their equivalents. The exclusive use of all modifications within the scope of the claims, as interpreted by the description and drawings, is reserved.

**Claims**

1. A device for measuring the square of the amplitude of an incoming signal comprising:

   a splitting means for splitting said incoming signal into a first part and a second part, wherein said first part is 90 degrees out of phase with said second part;
   a first squaring means for squaring said first part;
   a second squaring means for squaring said second part; and
   an adding means for adding said squared first part and said squared second part;
   whereby said added squared first part and said added squared second part produce a output signal proportional to the square of the amplitude of said incoming signal.

2. The device in accordance with claim 1, wherein said splitting means is a quadrature splitter.

3. The device in accordance with claim 1, wherein said incoming signal is generated within a plasma generator.

4. The device in accordance with claim 1, wherein said incoming signal is generated by a directional coupler.

5. The device in accordance with claim 1, wherein said incoming signal is a sinusoid signal.

6. The device in accordance with claim 1, wherein said incoming signal is a sum of sinusoid signals.

7. The device in accordance with claim 1, wherein said output signal is a DC signal.

8. The device in accordance with claim 1, wherein said first squaring means is an AD835 unit.

9. The device in accordance with claim 8, wherein said second squaring means is an AD835 unit.

10. The device in accordance with claim 9, wherein said adding means is integrated within one of said AD835 units.

11. The device in accordance with claim 1, wherein said adding means is a summing operational amplifier.

12. A method for measuring the square of the amplitude of a sinusoid signal comprising:

   splitting said sinusoid signal into a first part and a second part, wherein said first part is 90 degrees out of phase with said second part;
   squaring said first part;
   squaring said second part; and
   adding said squared first part and said squared second part,
   whereby said added squared first part and said added squared second part produce a output signal proportional to the square of the amplitude of said sinusoid signal.

13. The method in accordance with claim 12, wherein said splitting step is accomplished by a quadrature splitter.

14. The method in accordance with claim 12, wherein said sinusoid signal is generated within a plasma generator.

15. The method in accordance with claim 12, wherein said sinusoid signal is generated by a directional coupler.

16. The method in accordance with claim 12, wherein said first squaring step is accomplished by an AD835 unit.

17. The method in accordance with claim 16, wherein said second squaring step is accomplished by an AD835 unit.

18. The method in accordance with claim 17, wherein said adding step is accomplished by an AD835 unit.

19. The method in accordance with claim 12, wherein said adding step is accomplished by a summing operational amplifier.

FIG. 1

210 INPUT

220 QUADRATURE SPLITTER

m sin

m cos

230 $X^2$

240 $X^2$

$m^2 \sin^2 X$

$m^2 \cos^2$

250 $\Sigma$

$m^2$

FIG. 2

*FIG. 3*

EP 1 251 356 A2

FIG 4